# EUROPEAN PATENT SPECIFICATION

(11) **EP 3 052 946 B1**
(45) Date of publication and mention of the grant of the patent: **14.03.2018**
(21) Application number: 14809527.6
(22) Date of filing: 18.09.2014
(51) Int. Cl.: G01R 15/16, G01R 29/12, B29L 31/34, B29C 39/00, B29C 39/10, B29C 39/26, B29K 63/00, B29K 67/00, G01R 13/00, G01R 27/26, B29C 33/00, G01R 3/00

(54) **CAPACITIVE SENSOR TO SENSE AN ELECTRIC FIELD, SYSTEM AND METHOD TO OBTAIN IT**
KAPAZITIVER SENSOR ZUM ABTASTEN EINES ELEKTRISCHEN FELDES, SYSTEM UND VERFAHREN ZUR HERSTELLUNG
CAPTEUR CAPACITIF POUR DÉTECTER UN CHAMP ÉLECTRIQUE, SYSTÈME ET PROCÉDÉ DE PRODUCTION

(30) Priority: 30.09.2013 IT BO20130535
(43) Date of publication of application: 10.08.2016
(73) Proprietor: Green Seas Ventures, Ltd, VG 1110, Road Town, Tortola (VG)
(72) Inventor: BAUER, Alberto, Tierra Verde, Florida 33715 (US)
(74) Representative: Gustorf, Gerhard
(86) International application number: PCT/IT2014/000251
(87) International publication number: WO 2015/044972

(56) References cited:
- US-A- 4 311 959
- US-A- 4 551 785
- US-A1- 2009 126 984
- US-A1- 2011 205 683

## Description

### Technical Field

_The Present invention relates to a capacitive sensor for detecting an electric field, as well as a system and a method to obtain it.

_More in particular, the present invention relates to a capacitive sensor to detect an electric field, in which said capacitive sensor comprises a shielding tubular body, an electric field sensor and a source electrode and a resin of dielectric insulating material, as well as a system and a method for obtaining said capacitive sensor.

### Background of the Invention

_Currently, the capacitive sensors for detecting electrical fields, as well as systems and methods for obtaining them have a number of drawbacks.

_A first drawback is due to the fact that the resin of dielectric material positioned into and around the shielding body includes vacuoles (air bubbles), with consequent phenomena of unwanted partial discharges.

_A second drawback is due to the fact that the same resin is detached with respect to the shielding body and/or with respect to the electric field sensor and/or with respect to other bodies that make up the capacitive sensor, with consequent phenomena of unwanted partial discharges.

_A third drawback is due to the fact that the aforementioned resin is not perfectly adherent and/or it is not perfectly clinging and/or it is constrained with respect to the elements that make up the capacitive sensor and, therefore, as a result of aging, disjunctions occur between said resin and the above elements, in which said disjunctions cause unwanted partial discharges. _This drawback is particularly present when the capacitive sensor is used in an environment where the operating temperature (hot / cold) varies cyclically.

US 2011/0205683 A1 discloses a capacitive sensor for detecting an electric field as set forth in the preamble of claim 1. In that sensor the tubular shielding body has a closed cylindrical wall. Similar sensors are known from US 4 311 959 A and US 4 551 785 A.

US 2009/0126984 A1 relates to an electromagnetic shielding film and optical filter that are light transmittable and provided with opening portions in which moire preventing parts are formed.

### Object of the Invention

_The purpose of the present invention is to obviate the above drawbacks.

_The invention as characterized in claim 1 solves the above mentioned problems. Further characteristing features and modifications are set forth in the depending claims 2 to 12, whereas claims 13 and 14 relate to a system and to a method respectively to obtain said new sensor.

_By the capacitive sensor of the present invention, as well as by the related system and method to obtain it, a capacitive sensor having excellent characteristics with reference to the shield with respect to the surrounding electrical fields is obtained; in addition, the capacitive sensor is without vacuoles and any disjunctions.

### Brief Description of the Drawings

_Further characteristics and advantages of the present invention will be particularly evident from the following description of some preferred embodiments, here provided by way of non-limiting example and makes reference to the appended drawings, in which:
>_Figure 1 illustrates a first embodiment of a capacitive sensor of the present invention;
>_Figure 1A illustrates a second embodiment of a capacitive sensor of the present invention;
>_Figure 1B illustrates a third embodiment of a capacitive sensor of the present invention;
>_Figure 2 illustrates a shielding tubular body made by a sheet;
>_Figures 3 and 3A illustrate a shielding tubular body made by a sheet with first openings shaped like a rhombus, in which Figure 3A is a sectional view with respect to the line 3A_3A of Fig. 3;
>_Figures 4 and 4A illustrate a shielding tubular body made by a sheet with first openings shaped in the form of ellipse, in which figure 4A is a sectional view with respect to the line 4A_4A of Fig. 4;
>_Figures 5 and 5A illustrate a shielding tubular body made by a sheet with first openings shaped in the form of rectangular slot, in which the figure 5A is a sectional view with respect to the line 5A_5A of Fig. 5;
>_Figures 6 and 6A illustrate a shielding tubular body made of sheet with first openings shaped like a hexagon, in which the figure 6A is a sectional view with respect to the line 6A_6A of Fig. 6;
>_Figure 7 illustrates a shielding tubular body made up by mesh or grid or cloth of wires;
>_Figures 8 and 8A illustrate a shielding tubular body made by cloth of net having first openings shaped like a rhombus, in which Figure 8A is a sectional view with respect to the line 8A_8A of Fig. 8;
>_Figures 9 and 9A illustrate a shielding tubular body made by cloth of net having first openings shaped like a rectangle, in which the figure 9A is a sectional view with respect to the line 9A_9A of Fig. 9;
>_Figure 10 shows an example of a mesh having crimped wires that are intertwined with each other;
>_Figure 11 illustrates an example of a wire mesh having wires electro welded together;
>_Figure 12 illustrates a system and a method for manufacturing the capacitive sensor illustrated in Figure 1A.

### Best Mode of Carrying Out the Invention

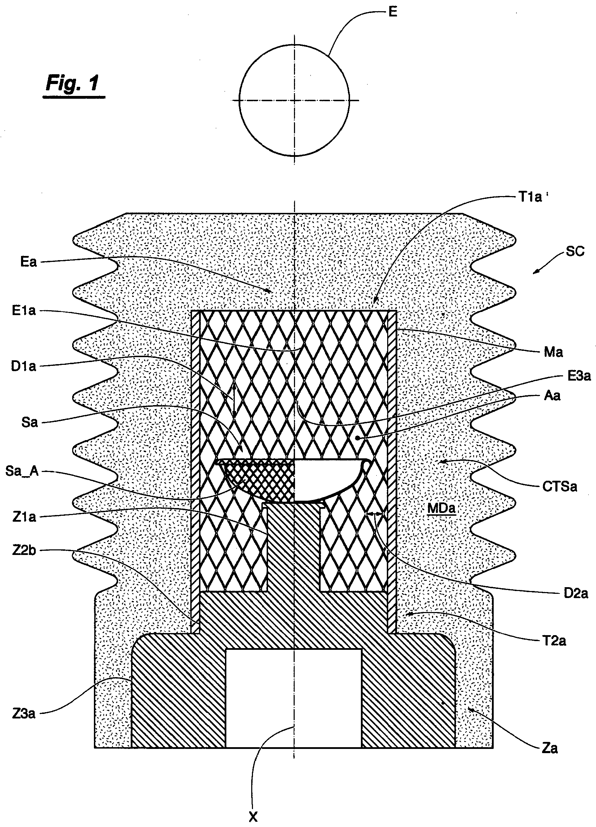

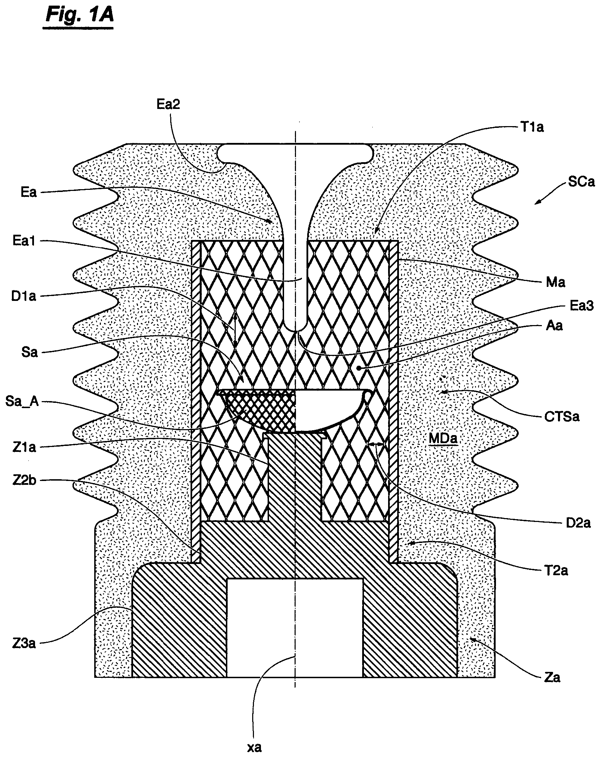

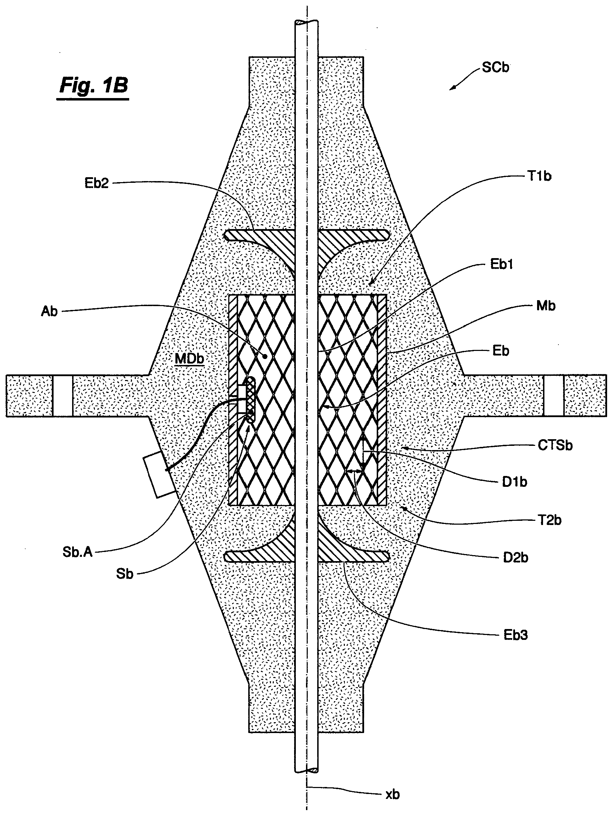

### Capacitive sensor Fig_1, Fig_1A and Fig_1B

_With reference to **Figure 1** it shows a first embodiment of a capacitive sensor indicated by the reference **SC,** in which said capacitive sensor comprises: _a shielding tubular body **CTSa**, which extends axially along its own axis **X** and which configures a first open end **T1a;** _an electric field sensor **Sa,** which is positioned within said shielding tubular body **CTSa**; _a source electrode **E** positioned in the proximity of said first open end **T1a**; _a mass of dielectric insulating material **MDa,** positoned within and around said shielding tubular body, **CTSa**, in which said mass is able to form a supporting structure.

_The shielding tubular body **CTSa** is formed by a mantle **Ma** comprising a plurality of first through openings **Aa**, in which each first through opening **Aa** has an area between a minimum of 0,1_mm² and a maximum of 3_mm².

_Each first through opening **Aa** has an elongated shape that configures a greater size **D1a** and a smaller size **D2a,** in which the greater size **D1a** is oriented parallel with respect to the axis **X** of the shielding tubular body **CTSa.**

_The mantle **Ma** of said shielding tubular body **CTSa** has a thickness comprised between a minimum of 0,05_mm and a maximum of 1_mm.

_With reference to the electric field sensor **Sa** it is positioned within said shielding tubular body **CTSa** and it is positioned in such way to form a capacitive coupling with the source electrode **E.**

_Furthermore, preferably, the electric field sensor **Sa** comprises a plurality of second through openings **SaA**.

_With reference to the source electrode **E,** in the specific embodiment of Fig._1, it is positioned externally and spaced with respect to the shielding tubular body **CTSa**, positioned near the first open end **T1a** and, more particularly, it is positioned axially spaced with respect to the first open end **T1a** of said shielding tubular body **CTSa.**

_With reference to **Figure_1A_and_1B,** they illustrate, schematically, respectively, a second and a third embodiment of a capacitive sensor, both object of the present invention, in which said two embodiments are indicated with the references **SCa** and **SCb** respectively.

_With reference to the following description, the references that have the letter **"a"** refer to Figure_1A and the references that have the letter **"b"** refer to Figure_1B.

_With reference to said Figures 1A and 1B, the capacitive sensor, SCa/SCb, comprises: _a shielding tubular body, **CTSa/CTSb,** which extends axially configuring a longitudinal axis, **Xa/Xb,** a first head, **T1a/T1b**, and a second head, **T2a/T2b;** _an electric field sensor, **Sa/Sb,** positioned within said shielding tubular body, CTSa/CTSb; _a voltage source electrode, **Ea/Eb,** which comprises a shank, **Ea1/Eb1,** which extends axially, **Xa/Xb,** within said shielding tubular body, **CTSa/CTSb;** _a mass of dielectric material, **MDa/MDb,** disposed within said shielding tubular body, **CTSa/CTSb,** as well as around said elements.

_The shielding tubular body **CTSa/CTSb** is formed by a mantle, **Ma/Mb,** having a plurality of first through-openings, **Aa/Ab**, in which each first through-opening, **Aa/Ab**, has an elongated shape that configures a greater size, **D1a/D1b,** and a minor size, **D2a/D2b,** in which the greater size, **D1a/D1b,** of each first through-opening, **Aa/Ab**, is oriented parallel to the axis, Xa/Xb, of the shielding tubular body, **CTSa/CTSb.**

_Preferabily, each first through opening **Aa/Ab** has an area between a minimum of 0,1_mm² and a maximum of 3_mm², and the mantle **Ma/Mb** of said shielding tubular body **CTSa/CTSb** has a thickness comprised between a minimum of 0,05_mm and a maximum of 1_mm.

_With reference to the electric field sensor, **Sa/Sb,** it is disposed within said shielding tubular body, **CTSa/CTSb,** and said electric field sensor, **Sa/Sb,** is positioned in such a way as to form a capacitive coupling with said source electrode, **Ea/Eb.**

_The electric field sensor, **Sa , Sb,** preferably, has a plurality of second through openings, **SaA, SbA.**

_With particular reference to the second embodiment illustrated in Figure_1A, the capacitive sensor **SCa** comprises a shielding tubular body **CTSa**, an electric field sensor **Sa,** a voltage source electrode **Ea,** a base **Za,** and a mass of dilectric material **MDa** formed, for example, by a resin dielectric material, positioned inside the shielding tubular body and outside the same shielding tubular body.

_With reference to the shielding tubular body **CTSa**, it extends axially and configures a longitudinal axis **Xa,** a first open end T1a and a second closed end **T2a.**

_With reference to the electric field sensor **Sa,** it is positoned within said shielding tubular body **CTSa** by the base **Za,** and it is positioned in such a way as to form a capacitive coupling with the source electrode **Ea.**

_Furthermore, preferably, said electric field sensor **Sa** has a shape like a cup and/or a spherical cap with opening facing the electrode **Ea** and it is preferably formed by a mantle having a plurality of second through openings **SaA**.

_With reference to the source electrode **Ea,** it is positioned near to the first end **T1a** of the shielding tubular body **CTSa** and, preferably, said source electrode **Ea** has a shape like a funnel (trumpet) with rounded sides and, substantially, it configures a shank **Ea1** having an axis which is coaxial within respect to the axis of said shielding tubular body CTSa, an optional head **Ea2** positioned near said first open head **T1a** and outside with respect to the shielding tubular body **CTSa**, and a free rounded end **Ea3** which extends towards the second end **T2a,** in which this end **E3a** is axially spaced with respect to the electric field sensor **Sa.**

_With reference to the base **Za,** it is positioned near the second end **T2a** of the shielding tubular body **CTSa** and, preferably, it has a shape like a cylindrical pyramid, and it configures a plurality of coaxial cylinders having different diameters between them.

_Said base **Za** comprises a first cylinder **Z1a** which supports in position the electric field sensor **Sa,** a second cylinder **Z2a** which is mechanically coupled with the second end **T2a** of the shielding tubular body CTSa, and a third cylinder, **Z3a,** which is positioned outside with respect to the shielding tubular body **CTSa.**

_Said shielding tubular body **CTSa** is formed by a mantle **Ma** comprising a plurality of first through openings **Aa**, in which each first through opening **Aa** has an elongated shape configuring a greater size **D1a** and a smaller size **D2b,** in which the greater size **D1a** is oriented parallel with respect to the axis **Xa** of the shielding tubular body **CTSa.**

_Preferably, each first through opening **Aa** has an area between a minimum of 0.1_mm² and a maximum of 3_mm², and the mantle **Ma** of said shielding tubular body **CTSa** has a thickness comprised between a minimum of 0.05_mm and a maximum of 1_mm.

_With reference to the shielding tubular body **CTSa** having the first openings **Aa**, as better described below, said shielding tubular body **CTSa** can be obtained by an expanded metal sheet, or by perforated metal sheet, or by a mesh/grid/cloth formed by a plurality of wires.

_With particular reference to the third embodiment illustrated in **Figure**_**1B**, the capacitive sensor **SCb** comprises a shielding tubular body **CTSb,** an electric field sensor **Sb,** a live source electrode **Eb** having a shank **E1b** which extends within said shielding tubular body **CTSb ,** and a mass of dielectric material **MDb** formed, for example, by a resin of dielectric material positioned inside the tubular body and outside of the same shielding tubular body **CTSb.**

_Said electric field sensor **Sb** is positioned radially spaced with respect to said shank **Eb1** in order to form a capacitive coupling between them and, preferably, said electric field sensor **Sb** has a shape in the form of foil having a plurality of second through openings **SbA.**

_With reference to the electrode source **Eb,** it includes said shank **Eb1,** a first optional head **Eb2,** and a second optional head **Eb3.**

_Said first head **Eb2** is positioned externally with respect to the shielding tubular body **CTSb** and, more particularly, it is positioned near and spaced with respect to the axial end of the first head **T1b**.

_Said shank **Eb1** has an axis **Xb** which extends axially within said shielding tubular body **CTSb.**

_Said second head **Eb3** is positioned externally with respect to the shielding tubular body **CTSb** and, more particularly, it is positioned near and spaced with respect to the ends of the second head **T2b.**
- As already provided in the first embodiment of Figure 1A, said shielding tubular body **CTSb** is formed by a mantle **Mb** comprising a plurality of first through openings **Ab,** in which each single through opening **Ab** has an elongated shape that configures a greater size **D1b** and a smaller size **D2b,** in which the greatest size **D1b** is oriented parallel with respect to the axis **Xb** of the shielding tubular body **CTSb.**

_Still as provided in the first embodiment of Figure 1A, preferably, each through opening **Ab** has an area between a minimum of 0,1_mm² and a maximum of 3_mm², and the mantle **Mb** of said shielding tubular body **CTSb** has a thickness comprised between a minimum of 0,05_mm and a maximum of 1_mm.

_As provided in the first embodiment of Figure 1A, preferably, the shielding tubular body **CTSb** with openings **Ab,** as more detailed below, can be obtained by an expanded metal sheet, or by a perforated metal sheet, or by a mesh/grid/cloth composed by a plurality of wires.

### Sheet With First Openings (expanded or perforated)

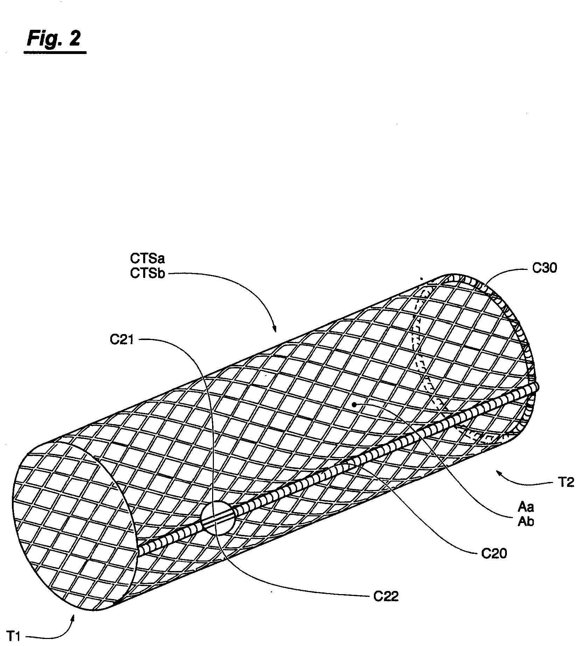

_With reference to **Figure**_**2**, it illustrates a shielding tubular body, **CTSa**, **CTSb,** of the type described above with reference to Figures 1, 1A et 1B, obtained by a sheet of expanded metal network (micro-expanded) or by means of a perforated metal sheet, in both cases, comprising the first openings **Aa/Ab.**

_More particularly said shielding tubular body, **CTSa**, **CTSb,** can be realized by a metal sheet having first openings **Aa/Ab**, folded in a tubular manner, and comprising a first weld bead **C20** which extends axially, in which said weld bead **C20** is able to join together two axial edges **C21** and **C22** of the folded sheet in the tubular form.

_Preferably, said shielding tubular body, **CTSa**, **CTSb,** also comprises at least a second bead **C30** of weld material, disposed around at least a head **T2** of said shielding tubular body, **CTSa**, **CTSb.**

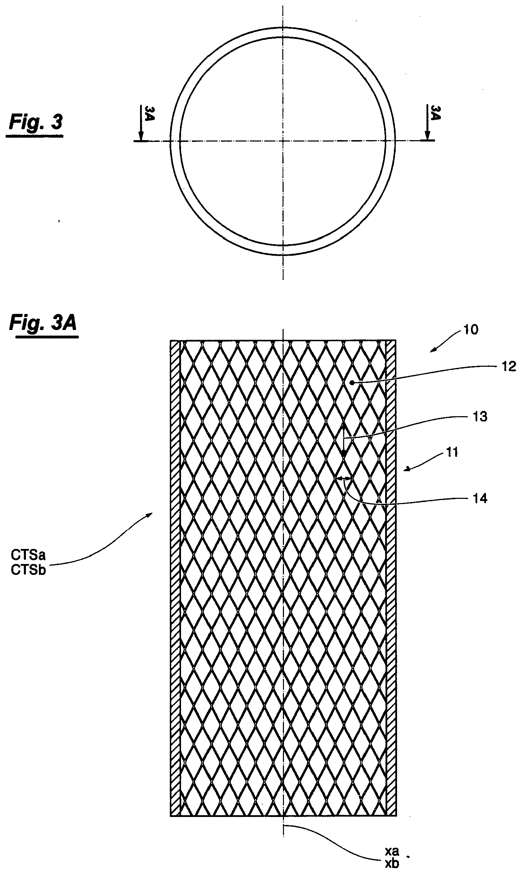

_With reference to **Figure**_**3**_**e**_**3A**, they illustrate a first preferred embodiment of a shielding tubular body **10** obtained by means of an expanded metal sheet or perforated metal sheet of the above type.

_Said shielding tubular body **10** is formed by a mantle **11** having a plurality of first through openings **12** shaped like a rhombus, in which each rhombus configures a long diagonal 13 and a short diagonal 14, in which the long diagonals **13** of each rhombus are oriented parallel with respect to the axis, Xa/Xb, of the shielding tubular body **10.**

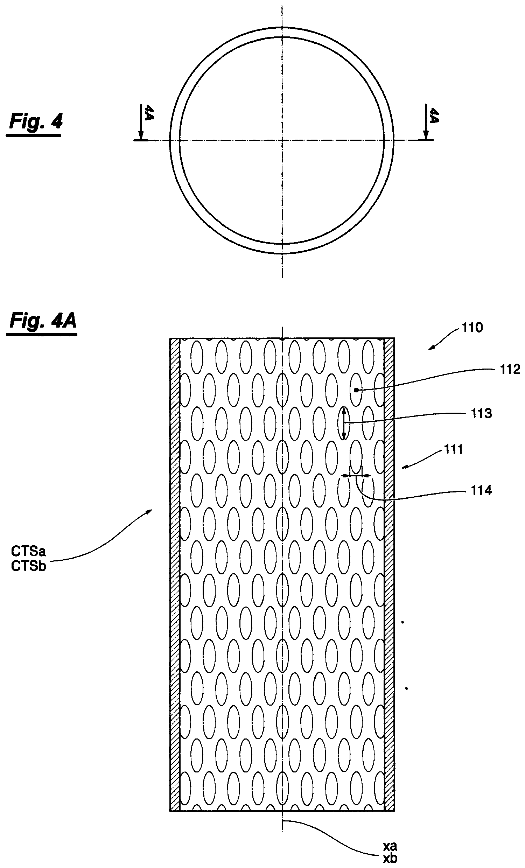

_With reference to **Figure_4_and_4A,** they illustrate a second preferred embodiment of the shielding tubular body **110** otained by means of an expanded metal sheet or perforated metal sheet of the above type.

_Said shielding tubular body **110** is obtained by a mantle **111** having a plurality of first through openings **112** which are shaped in the form of an ellipse, wherein each ellipse configures a long axis **113** and a short axis **114,** in which the long axis **113** of each ellipse is oriented parallel with respect to the axis, **Xa/Xb,** of the shielding tubular body **110.**

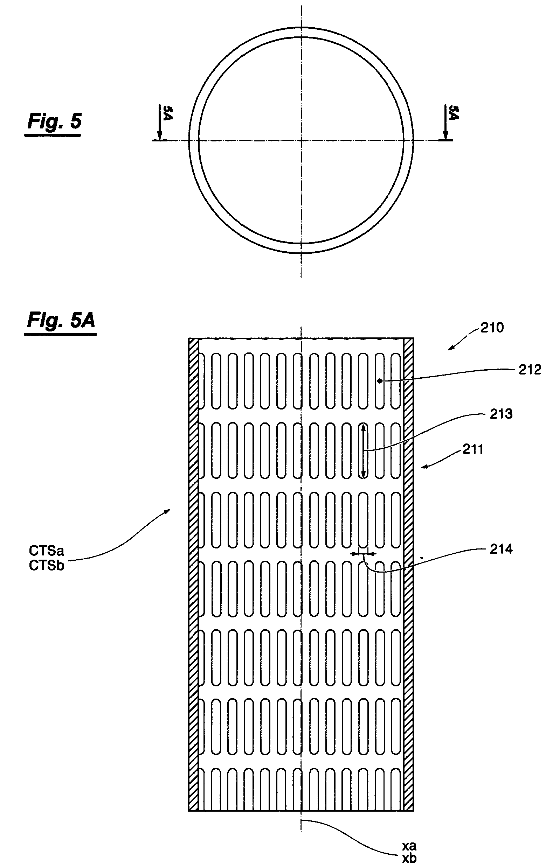

_With reference to **Figures_5_and_5A,** they illustrate a third preferred embodiment of the shielding tubular body **210** obtained by means of an expanded metal sheet or a perforated metal sheet of the above type.

_Said shielding tubular body **210** is formed by a mantle **211** comprising a plurality of first through openings **212** that are shaped in the manner of an oblong slot, wherein each oblong slot configures a long axis **213** and a short axis **214,** in which the long axis **213** of each oblong slot is oriented parallel with respect to the axis, **Xa/Xb,** of the shielding tubular body **210.**

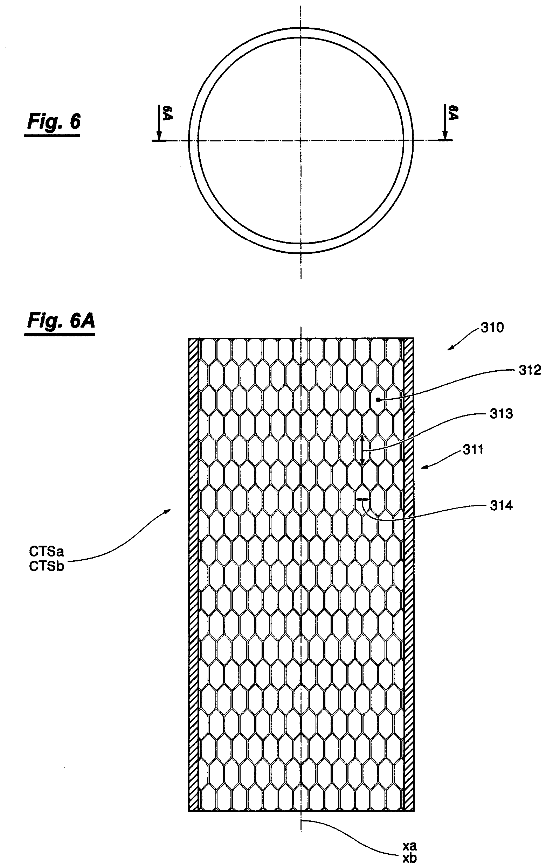

_With reference to **Figures_6_and_6A,** they illustrate a fourth preferred embodiment of the shielding tubular body **310** otained by means of a network of an expanded metal sheet or perforated metal sheet of the above type.

_Said shielding tubular body **310** is formed by a mantle **311** comprising a plurality of first through openings **312** that are shaped in the form of an elongated hexagon, wherein each elongated hexagon has a long axis **313** and a short axis **314,** in which the long axes **313** of each elongated hexagon are oriented parallel with respect to the axis, **Xa/Xb,** of the shielding tubular body **310.**

### Mesh or Cloths With First Openings

_With reference to **Figures 1** **and** **1A****,** said shielding tubular body, **CTSa/CTSb,** can be obtained by a mesh or grid or cloth, in which said mesh or grid or cloth comprises wires of conductor material, in which said wires are intersected and/or intertwined with each other, in which said mesh or grid or cloth configures said plurality of first openings, **Aa**/**Ab**.

_Preferably, each first opening, **Aa/Ab**, has an area between a minimum of 0.3_mm² and a maximum of 1.5_mm².

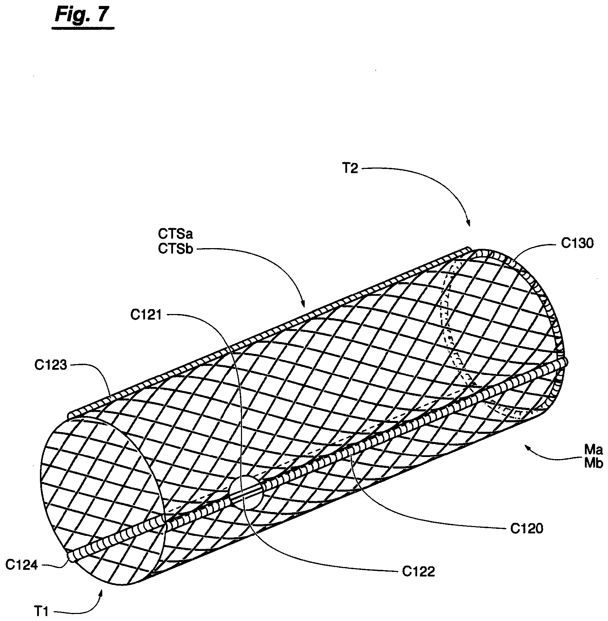

_With reference to **Figure 7****,** it illustrates a shielding tubular body, **CTSa**, **CTSb,** of the type above described with reference to Figures 1, 1A and 1B, here formed by a sheet of mesh or grid or cloth otained by metal wires.

_Said shielding tubular body, **CTSa/CTSb,** comprises a first weld bead **C120** which extends axially along the mantle, **Ma/Mb,** in which said first weld bead **C120** is able to join together the two opposite axial edges, **C121, C122,** of a sheet of mesh or grid or cloth wrapped in a tubular form.

_Preferably, said shielding tubular body, **CTSa / CTSb,** comprises one or more second axial beads, **C123, C124,** of weld material, positioned on the mantle, **Ma, Mb,** in which said second beads **C123, C124** act as reinforcement for the structure of the shelding tubular body.
- Preferably, said shielding tubular body, CTSa/CTSb, comprises at least one third bead, **C130,** of weld material, positioned around at least a head **T2** of the shielding tubular body, **CTSa / CTSb.**

_Said first bead **C120** and/or said one or more second beads **C123 C124** and/or said third bead **C130 ,** are preferably obtained by means of a tin alloy.

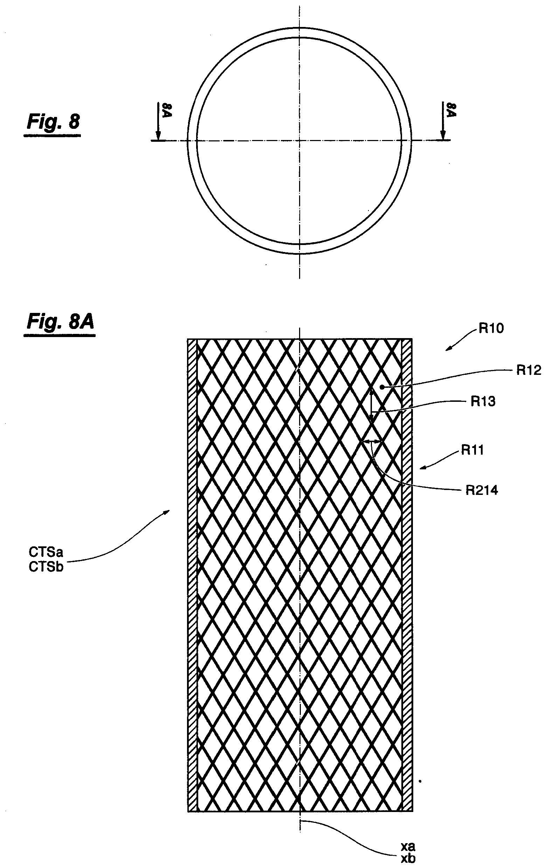

_With reference to **Figure 8** and **8A****,** they illustrate a first preferred embodiment of a shielding tubular body **R10** obtained by a mesh or grid or cloth comprising metal wires.

_Said shielding tubular body **R10** is formed by a mantle **R11** having a plurality of first openings **R12** shaped like a rhombus, where each rhombus configures a long diagonal **R13** and a short diagonal **R14,** in which the long diagonals **R13** of each rhombus are oriented parallel with respect to the longitudinal axis, **Xa/Xb,** of the shielding tubular body.

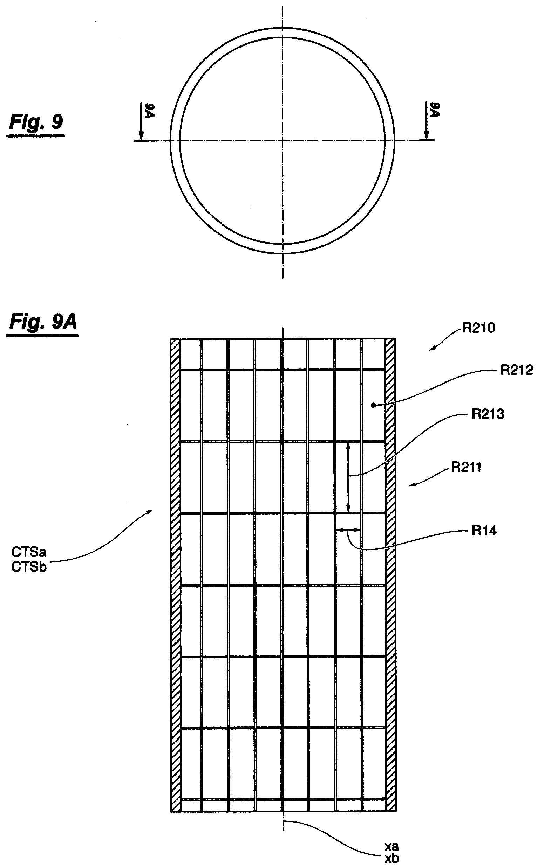

_With reference to **Figures 9 and 9A****,** they illustrate a second preferred embodiment of a shielding tubular body **R210** otained by a mesh or grid or cloth comprising metal wires.

_Said shielding tubular body **R210** is formed by a mantle **R211** having a plurality of first openings **R212** shaped like a rectangle, in which each rectangle configures a longer side **R213** and a shorter side **R214,** in which the longer sides of each rectangle are oriented parallel with respect to the longitudinal axis, **Xa/Xb,** of the shielding tubular body.

_With reference to the embodiments of the shielding tubular body obtained by a mesh or grid or cloth comprising metal wires, said wires can have a circular cross section and, preferably, said circular cross section has a diameter comprised between a minimum of 0,01_mm and a maximum of 1_mm.

_Said wires of the mesh or grid or cloth, may also have an elliptical cross section, in which said elliptical cross section preferably has an area comprised between a minimum of 0,01_mm² and a maximum of 0,8_mm², or, a square cross section, in which said square cross section has an area comprised between a minimum of 0,001_mm² and a maximum of 0,8_mm², or a hexagonal cross section, in which said hexagonal cross section has an area comprised between a minimum of 0,01_mm² and a maximum of 0,8_mm².

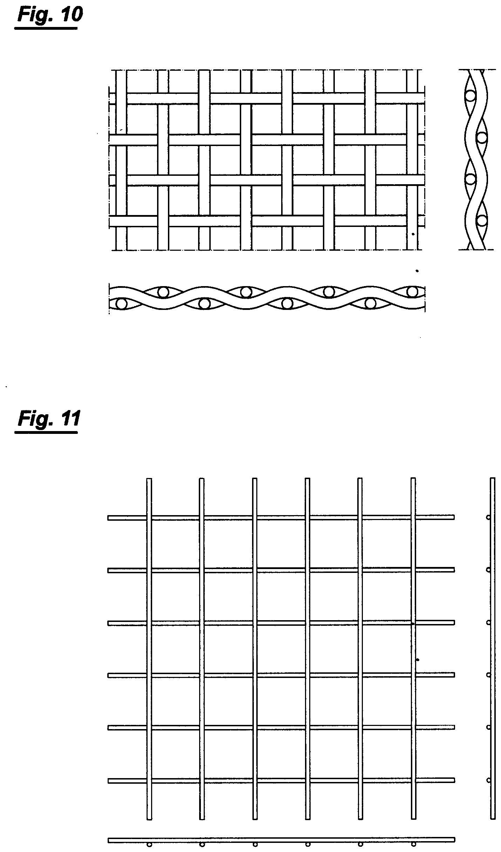

_With reference to **Figure 10****,** the mesh or grid or cloth above mentioned used to obtain the shielding tubular body may be formed by crimped wires that are intertwined with each other.

_Still with reference to **Figure 10****,** by way of not limiting example, said mesh or grid or cloth can comprise a first set of wires and a second set of wires, in which the first set of wires intersect the second set of wires forming a grid which configures the above first openings, wherein said first set of wires and said second set of wires form points of intersection/contact, in which said points of intersection/contact configure segments of wires, in which in said point of intersection/contact the respective first wires and the respective second wires are free to move with respect to each other (as flexure) with limited freedom of movement, as for example up to a maximum displacement of about 0,5_mm.

_With reference to this embodiment, during the hot casting of the resin in the liquid state and during the cooling of the same resin, with relative thermo-expansion and thermo-shrinking, the wires of the mesh or grid or cloth adhere to the resin.

_With reference to **Figure 11****,** the sheet of the mesh or grid or cloth above mentioned used to obtain the shielding tubular body may comprise electro welded wires, in which said wires intersect each other.

### Electric Field Sensor

_With reference to **figures 1** **and** **1A****,** the capacitive sensor **Sa** preferably has a shape in the form of a cup and/or spherical cap with the opening facing the electrode **Ea,** in which said cup and/or spherical cap is formed by a mantle having a plurality of second through openings **SaA**, in which said second through openings **SaA** preferably have the same dimensions of the openings **Aa** and **Ab** of the shielding tubular body **CTSa**, **CTSb.**

_With reference to **Figure 1** **B,** the capacitive sensor **Sb** preferably has a shape in the form a foil and includes a plurality of second through openings **SbA,** in which even said second through openings **SbA** preferably have the same sizes of the openings **Aa** and **Ab** of the shielding tubular body **CTSa**, **CTSb.**

### System to Obtain a Capacitive Sensor

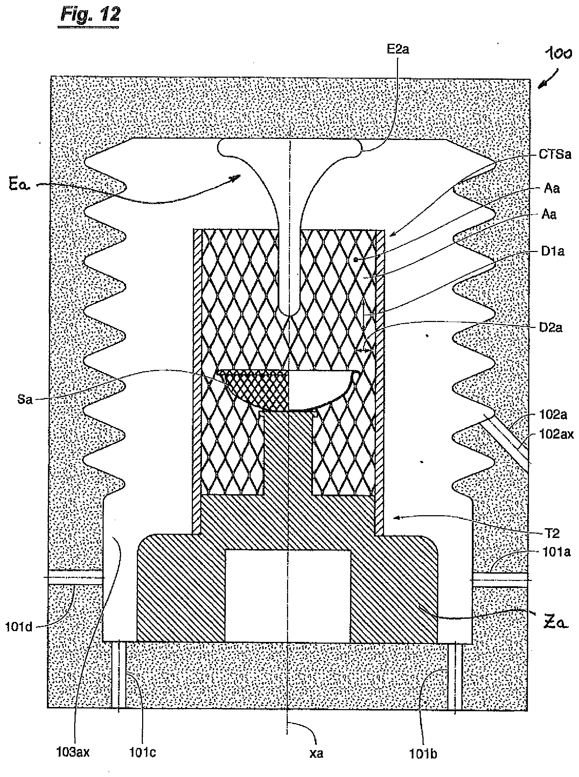

_With reference to **Figure 12****,** it shows a preferred embodiment of a system used to obtain a capacitive sensor to detect an electric field, i.e. a capacitive sensor of the type described above with reference to figures 1 or 1A.

_In this context, the same system can also be used to obtain in the same way a capacitive sensor for detecting an electric field of the type described above with reference to Figure 1B.

_In this context, in the following description, the references with the letter **"a"** refer to the capacitive sensor of Figs. 1 and 1A, while references with the letter **"b"** refer to the second capacitive sensor of Figure 1B.

_With reference to the above **Figure 12****,** and substantially synthetically, the system comprises: _a tubular shielding body, **CTSa/CTSb,** in which said tubular shielding body extends axially along its own axis **Xa/Xb** and configures a first head **T1 a/T1 b** and a second head **T2a/T2b;** _an electric field sensor **Sa/Sb,** in which said electric field sensor is positioned within said shielding tubular body **CTSa/CTSb;** _a source electrode **E** arranged externally with respect to said shielding tubular body and positioned near the first open end, or a source electrode, **Ea/Eb,** having a shank, **Ea1**/**Eb1**, positioned coaxially within the shielding tubular body, **CTSa/CTSb;** _a mass **MDa** of dielectric insulating material, positoned within said shielding tubular body **CTSa/CTSb,** and around these elements; _a mold **100** comprising one or more pouring ducts **101a, 101b,** etc..

_With reference to the tubular shielding body, **CTSa/CTSb,** it is formed by a mantle, **Ma/Mb,** comprising a plurality of first through-openings, **Aa/Ab**, in which said first through openings **Aa/Ab** have an elongated shape intended to configure a long size, **D1a/D1b,** and a small size, **D2a/D2b,** in which the long size, **D1a/D2b,** of each through-opening, **Aa/Ab**, is oriented parallel to the axis, **Xa/Xb,** of the shielding tubular body, **CTSa/CTSb.**

_With reference to the mass of dielectric insulating material, **MDa,** positioned inside the shielding tubular body, **CTSa/CTSb,** said mass **MDa** is obtained by means of a compound that can take a first liquid/pasty state and a second solid state.

_By means of said system, through the pouring ducts **101a, 101b, etc.,** the particular compound in its first liquid/paste state is poured towards and against the outside mantle **Ma/Mb** of the shielding tubular body **CTSa/CTSb,** and said compound in its first liquid/pasty state through said plurality of first through openings **Aa/Ab** flows into the shielding tubular body **CTSa/CTSb.**

_Still with reference to said system, preferably, said shielding tubular body is positioned and supported in a cantilevered manner within the mold 100, by means of its head **T2a** associated with the base **Za,** where the latter is supported in position by the mold **100.**

_Still with reference to this system, more preferably, said source electrode **Ea** is positioned in a cantilever manner within the mold **100** by its head **E2a** supported in position by the mold **100.**

### Method to get a Capacitive Sensor by the System

_With reference to **Figure 12** and to the above description regarding the system to get a capacitive sensor, the present invention also concerns a method for obtaining said capacitive sensor, wherein said method is characterized in that it comprises an operative step in which said compound in its first liquid/pasty state flows/passes through said plurality of first through openings **Aa/Ab**, inside the tubular shielding body, **CTSa/CTSb,** in order to obtain the formation of the mass of insulating material, **MDa/MDb** within the same shielding tubular body CTSa/CTSb.

_By this methodological technical feature, the liquid/pasty compound is positioned within the shielding tubular body **CTSa/CTSb** without formation of air bubbles and with perfect adhesion between the shielding tubular body **CTSa/CTSb** and resin **MDa/MDb.**

### Compound for the Formation of the Mass of Insulation Dielectric Material

_With reference to the mass of dielectric material, **MDa/MDb,** preferably, it comprises an epoxy resin of the insulating dielectric material, or a compound of polyester.

## Claims

1. Capacitive sensor to sense an electric field, in which said capacitve sensor comprises: >_a shielding tubular body (CTSa, CTSb), which extends axially along its own axis and configures a first open end (T1a, T1b) and a second end (T2a, T2b); >_an electric field sensor (Sa, Sb) positioned within said shielding tubular body; >_a source electrode (E, Ea, Eb); >_a mass of dielectric insulating material (MDa, MDb) positioned within said shielding tubular body and around said shielding tubular body, **characterized in that** the shielding tubular body **(CTSa, CTSb)** is formed by a mantle **(Ma, Mb,)** having a plurality of first through openings **(Aa, Ab),** and **in that** each of said first through openings **(Aa, Ab)** has an area comprised between a minimum of **0.1_mm²** and a maximum of **3_mm².**

2. Capacitive sensor according to claim 1, wherein said plurality of first through openings **(Aa, Ab)** have an elongated shape, wherein each through opening, of said plurality of first through openings, configures a long size **(D1a, D1b)** and short size **(D2a, D2b),** and the long size **(D1a, D1b)** of each through opening **(Aa, Ab)** is oriented parallel with respect to the axis **(X, Xa, Xb)** of the shielding tubular body **(CTSa, CTSb).**

3. Capacitive sensor according to one of the preceding claims, wherein said electric field sensor **(Sa, Sb)** has a plurality of second through openings **(SaA, SbA).**

4. Capacitive sensor according to one of claims 01 to 03, wherein said source electrode **(E)** is positioned externally with respect to the shielding tubular body **(CTSa)** and said source electrode **(E)** is positioned axially **(X)** spaced with respect to the first open end **(T1a)** of said shielding tubular body **(CTSa).**

5. Capacitive sensor according to one of claims 01 to 03, wherein the second end is a second opposite closed end **(T2a);** said source electrode **(Ea)** comprises a shank **(Ea1)** and a free end **(Ea3);** said shank **(E1a)** extends axially **(Xa)** within said shielding tubular body **(CTSa)** and towards the second end **(T2a)** of the shielding tubular body **(CTSa);** said free end **(Ea3)** is positioned within said shielding tubular body **(CTSa),** and said free end **(Ea3)** is axially spaced with respect to the electric field sensor **(Sa).**

6. Capacitive sensor according to one of claims from 01 to 03, wherein the second end is an opposite second closed end **(T2a);** said source electrode **(Ea)** comprises a head **(Ea2)** a shank **(Ea1)** and a free end **(Ea3);** said head **(Ea2)** is positioned near the first open end **(T1a)** of the shielding tubular body **(CTSa)** and outside with respect to the same shielding tubular body **(CTSa);** said shank **(E1a)** extends axially **(Xa)** within said tubular shielding body **(CTSa)** and towards the second end **(T2a)** of the shielding tubular body **(CTSa);** said free end **(Ea3)** is positioned within said shielding tubular body **(CTSa),** and said free end **(Ea3)** is axially spaced with respect to the electric field sensor **(Sa).**

7. Capacitive sensor according to claim 05 or 06, wherein the electric field sensor **(Sa)** has a shape like a cup and/or a spherical dome with opening facing the source electrode **(Ea).**

8. Capacitive sensor according to one of claims 01 to 03, wherein the second end is a second opposite open end **(T2b);** said source electrode **(Eb)** comprises a shank **(Eb1);** said shank **(Eb1)** extends axially **(Xb)** within and along said shielding tubular body **(CTSb)** and said electric field sensor **(Sb)** is positioned radially spaced with respect to said shank **(Eb1).**

9. Capacitive sensor according to one of claims from 01 to 03, wherein the second end is a second opposite open end **(T2b);** said source electrode **(Eb)** comprises a first head **(Eb2)** a shank **(Eb1)** and a second head **(Eb3);** said first head **(Eb2)** is positioned in proximity to said first open end **(T1b)** and externally with respect to the shielding tubular body **(CTSb);** said second head **(Eb3)** is positioned near said second open end **(T2b)** and externally with respect to the shielding tubular body shielding **(CTSb);** said shank **(Eb1)** extends axially **(Xb)** within and along said shielding tubular body **(CTSb)** and said electric field sensor **(Sb)** is positioned radially spaced with respect to said shank **(Eb1).**

10. Capacitive sensor according to one of claims from 01 to 09, wherein said shielding tubular body **(CTSa, CTSb)** is formed by means of a metal sheet having first through openings **(Aa, Ab)** and folded in the form of a tubular, and said shielding tubular body **(CTSa, CTSb)** comprises a first weld bead **(C20)** which extends axially and act to join together two axial edges **(C21, C22)** of the folded sheet in the form of a tubular.

11. Capacitive sensor according to one of claims from 01 to 09, wherein said shielding tubular body **(CTSa, CTSb)** is formed by means of a mesh or grid or cloth, **in which** said mesh or grid or cloth comprises wires which intersect each other; **in which** said mesh or grid or cloth, configures said plurality of first through openings **(Aa, Ab); in which** said wires are made of conductive material.

12. Capacitive sensor according to claim 11, wherein said mesh or grid or cloth comprises a first set of wires and a second set of wires; said first set of wires and said second set of wires intersect each other; said first set of wires and said second set of wires define a mesh/grid/cloth having through openings **(Aa, Ab);** said first set of wires and said second set of wires define points of intersection/contact between them; said first set of wires and said second set of wires define segments of wire delimited by said points of intersection/contact, and in these said points of intersection/contact the respective first wires and the respective second wires are movable relative to each other.

13. System to obtain a capacitive sensor according to any one of claims 1 to 12, the system comprising:
- a mold **(100)** comprising one or more pouring ducts **(101a, 101b, etc.);** wherein said mass of dielectric insulating material (MDa, MDb) disposed within the shielding tubular body (CTSa, CTSb) is obtained by a compound that can take a first liquid/pasty state and a second solid state, and wherein by said pouring ducts **(101a, 101b, etc.)** the compound in its first liquid/pasty state is cast towards and against the outside of the mantle (Ma, Mb) of the shielding tubular body (CTSa, CTSb).

14. Method to obtain a capacitive sensor to sense an electric field, in which said capacitive sensor comprises:: >_a shielding tubular body (CTSa, CTSb), which extends axially along its own axis (Xa, Xb) and configures a first open end (T1a, T1b) and a second end (T2a, T2b); >_an electric field sensor (Sa, Sb) positioned within said shielding tubular body (CTSa, CTSb) >_a source electrode **(E),** arranged outside with respect to the shielding tubular body and near said first open end (T1a, T1b) or a source electrode (Ea, Eb) having a shank (EA1, Eb1) positioned coaxially inside the shielding tubular body (CTSa, CTSb); >_a mass of dielectric insulating material (MDa, MDb) positioned within said shielding tubular body (CTSa, CTSb), wherein the said shielding tubular body is formed by a mantle **(Ma, Mb)** having a plurality of first through openings **(Aa, Ab);** each opening of said plurality of first through openings having an elongated shape that configures a long size **(D1a, D1b)** and a short size **(D2a, D2b);** the long size **(D1a, D1b)** being oriented parallel with respect to the axis **(X, Xa**, **Xb)** of the shielding tubular body **(CTSa, CTSb);** wherein the mass of dielectric insulating material (MDa, MDb) disposed within the shielding tubular body CTSa, CTSb) is obtained by means of a compound that can take a first liquid/pasty state and a second solid state, wherein said method comprises an operative step in which said compound in its first liquid/pasty state flows/passes through said plurality of first through openings (Aa, Ab) inside the tubular body shielding (CTSa, CTSb) in order to obtain the formation of the mass of insulating material (MDa, MDb) within the shielding tubular body (CTSa, CTSb).

## Patentansprüche

1. Kapazitiver Sensor zum Erfassen eines elektrischen Feldes, wobei der Sensor aufweist:
- einen rohrförmigen Abschirmkörper (CTSa, CTSb), der sich entlang seiner Achse erstreckt und ein erstes, offenes Ende (T1a, T1b) sowie ein zweites Ende (T2a, T2b) hat,
- einen elektrischen Feldsensor (Sa, Sb), der in dem rohrförmigen Abschirmkörper angeordnet ist,
- eine Source-Elektrode (E, Ea, Eb),
- eine Masse eines dielektrischen Isoliermaterials (MDa, MDb), die in dem rohrförmigen Abschirmkörper um diesen herum angebracht ist,
**dadurch gekennzeichnet, dass** der rohrförmige Abschirmkörper (CTSa, CTSb) aus einem Mantel (Ma, Mb) mit einer Vielzahl von ersten, durchgehenden Öffnungen (Aa, Ab) besteht, von denen jede Öffnung (Aa, Ab) eine Fläche zwischen wenigstens 0,1mm² und höchstens 3mm² hat.

2. Kapazitiver Sensor nach Anspruch 1, **dadurch gekennzeichnet, dass** die ersten Öffnungen (Aa, Ab) eine längliche Form haben und jede Öffnung eine lange Weite (D1a, D1b) und eine kurze Weite (D2a, D2b) aufweist, wobei die lange Weite (D1a, D1b) parallel zur Achse (X, Xa, Xb) des Abschirmkörpers (CTSa, CTSb) ausgerichtet ist.

3. Kapazitiver Sensor nach Anspruch 1 oder 2, **dadurch gekennzeichnet, dass** der elektrische Feldsensor (Sa, Sb) eine Vielzahl von zweiten durchgehenden Öffnungen (SaA, SbA) hat.

4. Kapazitiver Sensor nach einem der Ansprüche 1 bis 3, **dadurch gekennzeichnet, dass** die Source-Elektrode (E) außerhalb des rohrförmigen Abschirmköpers (CTSa) angeordnet ist und zu dem ersten, offenen Ende (T1a) des Abschirmkörpers (CTSa) einen axialen Abstand hat.

5. Kapazitiver Sensor nach einem der Ansprüche 1 bis 3, **dadurch gekennzeichnet, dass** das zweite Ende ein gegenüberliegendes, geschlossenes Ende (T2a) ist und die Source-Elektrode (Ea) einen Schaft (Ea1) und ein freies Ende (Ea3) hat, wobei sich der Schaft (Ea1) in dem rohrförmigen Abschirmköper (CTSa) in axialer Richtung zum zweiten freien Ende (T2a) des Abschirmkörpers (CTSa) hin erstreckt, wobei das freie Ende (Ea3) des Schafts in den rohrförmigen Abschirmköper (CTSa) hineinragt und zu dem elektrischen Feldsensor (Sa) einen axialen Abstand hat.

6. Kapazitiver Sensor nach einem der Ansprüche 1 bis 3, **dadurch gekennzeichnet, dass** das zweite Ende ein gegenüberliegendes, geschlossenes Ende (T2a) ist und die Source-Elektrode (Ea) einen Kopf (Ea2), einen Schaft (Ea1) und ein freies Ende (Ea3) hat, wobei der Kopf (Ea2) in der Nähe des ersten, offenen Endes (T1a) des rohrförmigen Abschirmkörpers (CTSa) und außerhalb von diesem liegt und sich der Schaft (Ea1) in dem rohrförmigen Abschirmkörper (CTSa) axial (Xa) zu dessen zweitem Ende (T2a) hin erstreckt, während das freie Ende (Ea3) des Schafts innerhalb des Abschirmkörpers (CTSa) liegt und einen axialen Abstand zu dem elektrischen Feldsensor (Sa) hat.

7. Kapazitiver Sensor nach Anspruch 5 oder 6, **dadurch gekennzeichnet, dass** der elektrische Feldsensor (Sa) die Form einer Schale und/oder einer kugelförmigen Kuppel mit einer der Source-Elektrode (Ea) zugewandten Öffnung hat.

8. Kapazitiver Sensor nach einem der Ansprüche 1 bis 3, **dadurch gekennzeichnet, dass** das zweite Ende ein gegenüberliegendes, offenes Ende (T2b) ist und die Source-Elektrode (Eb) einen Schaft (Eb1) hat, der sich in dem rohrförmigen Abschirmkörper (CTSb) in axialer Richtung (Xb) erstreckt, wobei der elektrische Feldsensor (Sb) zu dem Schaft (Eb1) mit radialem Abstand angeordnet ist.

9. Kapazitiver Sensor nach einem der Ansprüche 1 bis 3, **dadurch gekennzeichnet, dass** das zweite Ende ein gegenüberliegendes, offenes Ende (T2b) ist und die Source-Elektrode (Eb) einen ersten Kopf (Eb2), einen Schaft (Eb1) und einen zweiten Kopf (Eb3) hat, wobei der erste Kopf (Eb2) in der Nähe des ersten offenen Endes (T1b) außerhalb des rohrförmigen Abschirmkörpers (CTSb) und der zweite Kopf (Eb3) außerhalb des Abschirmkörpers (CTSb) in der Nähe von dessen zweitem offenen Endes (T2b) liegt, wobei sich der Schaft (Eb1) innerhalb des rohrförmigen Abschirmkörpers (CTSb) in axialer Richtung (Xb) erstreckt und der elektrische Feldsensor (Sb) mit radialem Abstand von dem Schaft (Eb1) angeordnet ist.

10. Kapazitiver Sensor nach einem der Ansprüche 1 bis 9, **dadurch gekennzeichnet, dass** der rohrförmige Abschirmkörper (CTSa, CTSb) aus einem rohrförmig gebogenen Metallblech mit durchgehenden Öffnungen (Aa, Ab) gebildet und mit einer ersten Schweißraupe (C20) versehen ist, die sich axial erstreckt und die beiden axial verlaufenden Ränder (C21, C22) des rohrförmig gebogenen Bleches miteinander verbindet.

11. Kapazitiver Sensor nach einem der Ansprüche 1 bis 9, **dadurch gekennzeichnet, dass** der rohrförmige Abschirmkörper (CTSa, CTSb) aus einem Sieb oder Gitter oder Gewebe gebildet ist, bestehend aus einander sich kreuzenden Drähten aus leitendem Material und versehen mit den ersten durchgehenden Öffnungen (Aa, Ab).

12. Kapazitiver Sensor nach Anspruch 11, **dadurch gekennzeichnet, dass** das Sieb oder Gitter oder Gewebe aus einer ersten Gruppe von Drähten und einer zweiten Gruppe von die Drähte der ersten Gruppe kreuzenden Drähten besteht, wobei die erste und die zweite Gruppe von Drähten ein Sieb, ein Gitter oder ein Gewebe mit durchgehenden Öffnungen (Aa, Ab) und Kreuzungs- oder Kontaktpunkten bilden, durch die die Drahtabschnitte begrenzt werden, die relativ zueinander beweglich sind.

13. System zur Herstellung eines kapazitiven Sensors nach einem der vorhergehenden Ansprüche, umfassend
- ein Formwerkzeug (100) mit einem oder mehreren Gießkanälen (101a, 101b, etc.), wobei die Masse des dielektrischen Isoliermaterials (MDa, MDb) in dem rohrförmigen Abschirmkörper (CTSa, CTSb) aus einer Verbindung hergestellt wird, die einen ersten, flüssigen oder teigigen Zustand und einen zweiten, festen Zustand hat, wobei die Verbindung in ihrem ersten, flüssigen oder teigigen Zustand durch die Gießkanäle (101a, 101b etc.) in Richtung auf und gegen die Außenseite des Mantels (Ma, Mb) des rohrförmigen Abschirmkörpers (CTSa, CTSb) gegossen wird.

14. Verfahren zur Herstellung eines kapazitiven Sensors zum Erfassen eines elektrischen Feldes, umfassend:
- einen rohrförmigen Abschirmkörper (CTSb), welcher sich entlang seiner Achse in axialer Richtung erstreckt und ein erstes, offenes Ende (T1a, T1b) sowie ein zweites Ende (T2a, T2b) hat,
- einen elektrischen Feldsensor (Sa, Sb), der in dem rohrförmigen Abschirmkörper (CTSa, CTSb) angeordnet ist,
- eine Source-Elektrode (E) außerhalb des rohrförmigen Abschirmkörpers (CTSa, CTSb) und der Nähe von dessen erstem, offenen Ende (T1a, T1b)
- oder eine Source-Elektrode (Ea, Eb) mit einem Schaft (Ea1, Eb1), der sich innerhalb des rohrförmigen Abschirmkörpers (CTSa, CTSb) koaxial erstreckt,
- eine Masse eines dielektrischen Isoiermaterials (MDa, MDb), die in dem rohrförmigen Abschirmkörper (CTSa, CTSb) angebracht ist,
- wobei der rohrförmige Abschirmkörper aus einem Mantel (Ma, Mb) mit einer Vielzahl von ersten durchgehenden Öffnungen (Aa Ab) besteht, von denen jede eine längliche Form mit einer langen Weite (D1a, D1b) und einer kurzen Weite (D2a, D2b) hat, wobei die lange Weite (D1a, D1b) parallel zur Achse (X, Xa, Xb) des Abschirmkörpers (CTSa, CTSb) ausgerichtet ist,
- wobei die Masse des dielektrischen Isoliermaterials (Mda, Mdb) innerhalb des rohrförmigen Abschirmkörpers (CTSa, CTSb) hergestellt wird aus einer Verbindung, die einen ersten, flüssigen oder teigigen Zustand und einen zweiten, festen Zustand einnehmen kann,
- wobei das Verfahren einen operativen Schritt hat, bei dem die Verbindung in ihrem ersten, flüssigen oder teigigen Zustand durch die Vielzahl von ersten Durchgangsöffnungen (Aa, Ab) in den rohrförmigen Abschirmkörper (CTSa, CTSb) fließt, wodurch die Masse des Isoliermaterials (MDa, MDb) innerhalb des Abschirmkörpers (CTSa, CTSb) gebildet wird.

## Revendications

1. Capteur capacitif pour détecter un champ électrique, le capteur comprenant :
- un corps de blindage tubulaire (CTSa, CTSb) se dressant le long de son axe et présentant une première extrémité ouverte (T1a, T1b) et une seconde extrémité (T2a, T2b),
- un capteur de champs électriques (Sa, Sb) positionné dans le corps de blindage tubulaire,
- une électrode-source (E, Ea, Eb),
- une masse de matériau isolant diélectrique (MDa, MDb) englobant le corps de blindage tubulaire,
**caractérisé par le fait que** le corps de blindage tubulaire (CTSa, CTSb) présente un manteau (Ma, Mb) avec une plurarité de premières ouvertures passantes (Aa, Ab) dont la surface mesure entre au moins 0,1 mm² et au maximum 3mm².

2. Capteur capacitif selon la revendication 1 **caractérisé par le fait que** les premières ouvertures (Aa, Ab) présentent une forme allongée avec un côté long (D1a, D1b) et un côté court (D2a, D2b), le côté long (D1a, D1b) s'étendant parallèlement à l'axe (X, Xa, Xb) dudit corps de blindage (CTSa, CTSb).

3. Capteur capacitif selon la revendication 1 ou 2 **caractérisé par le fait que** le capteur de champs électriques (Sa, Sb) présente une pluralité de deuxièmes ouvertures passantes (SaA, SbA).

4. Capteur capacitif selon une des revendications 1 à 3 **caractérisé par le fait que** l'électrode-source (E) est positionnée en dehors du corps de blindage (CTSa) présentant une distance axiale à la première extrémité ouverte (T1a) dudit corps de blindage (CTSa).

5. Capteur capacitif selon une des revendications 1 à 3 **caractérisé par le fait que** la seconde extrémité est une extrémité opposée et fermée (T2a) et que l'électrode-source (Ea) présente une tige (Ea1) et une extrémité libre (Ea3), la tige (Ea1) s'étendant dans le corps de blindage tubulaire (CTSa) axialement (Xa) vers la seconde extrémité libre (T2a) dudit corps de blinage (CTSa), tandis que l'extrémité libre (Ea3) de ladite tige plonge dans le corps de blindage (CTSa) de sorte qu'elle présente une distance axiale au capteur de champs électriques (Sa).

6. Capteur capacitif selon une des revendications 1 à 3 **caractérisé par le fait que** la seconde extrémité est une extrémité opposée fermée (T2a) et que l'électrode-source (Ea) présente une tête (Ea2), une tige (Ea1) et une extrémité libre (Ea3), ladite tête (Ea2) étant positionnée au voisinage de la première extrémité ouverte (T1a) au-dehors du corps tubulaire de blindage (CTSa), tandis que la tige (Ea1) s'étend dans le corps de blindage (CTSa) axialement (Xa) vers sa seconde extrémité (T2a) tandis que l'extrémité libre (Ea3) de la tige est située dans le corps de blindage (CTSa), présentant une distance axiale au capteur de champs électriques (Sa).

7. Capteur capacitif selon la revendication 5 ou 6 **caractérisé par le fait que** le capteur de champs électriques (Sa) présente la forme d'une coupe et/ou d'une coupelle sphérique avec une ouverture faisant face à l'électrode-source (Ea).

8. Capteur capacitif selon une des revendications 1 à 3 **caractérisé par le fait que** la seconde extrémité est une extrémité opposée ouverte (T2b) et que l'électrode-source (Eb) présente une tige (Eb1) s'étendant axialement (Xb) dans le corps de blindage tubulaire (CTSb), le capteur de champs électriques (Sb) présentant une distance radiale à la tige (Eb1).

9. Capteur capacitif selon une des revendications 1 à 3 **caractérisé par le fait que** la seconde extrémité est une extrémité opposée ouverte (T2b) et que l'électrode-source (Eb) présente une première tête (Eb2), une tige (Eb1) et une seconde tête (Eb3), ladite première tête (Eb2) étant positionnée au voisinage de la première extrémité ouverte (T1b) au-dehors du corps tubulaire de blindage (CTSb), tandis que la seconde tête (Eb3) est positionnée au-dehors du corps de blindage (CTSb) au voisinage de sa seconde extrémité ouverte (T2b), la tige (Eb1) s'étendant axialement (Xb) dans le corps de blindage (CTSb), le capteur de champs électrique (Sb) ayant une distance radiale de la tige (Eb1).

10. Capteur capacitif selon une des revendications 1 à 9 **caractérisé par le fait que** le corps de blindage (CTSa, CTSb) est formé d'une plaque métallique recourbée en tube et présentant des ouvertures passantes (Aa, Ab) et un premier cordon de soudure axial (C20) réunissant les deux bords axiaux (C21, C22) de la plaque tubulaire.

11. Capteur capacitif selon une des revendications 1 à 9 **caractérisé par le fait que** le corps de blindage (CTSa, CTSb) est formé d'un tamis ou d'une grille ou d'un tissu, constitué par des fils croisés d'un matériau conducteur et représentant les dites premières ouvertures passantes (Aa, Ab).

12. Capteur capacitif selon la revendication 11 **caractérisé par le fait que** le tamis, la grille ou le tissu est constitué d'un premier groupe de fils et d'un second groupe de fils croisant les fils du premier groupe, le premier et le second groupe de fils formant le tamis, la grille ou le tissu avec des ouvertures passantes (Aa, Ab) et les points de contact ou de croisement par lesquels sont limités des portions de fils mobiles entre eux.

13. Système pour la réalisation d'un capteur capacitif selon une des revendications précédentes comprenant
un outil de moulage (100) avec un ou plusieurs canaux de coulage (101a, 101b, etc), la masse du matériau isolant diélectrique (MDa, MDb) dans le corps de blindage tubulaire (CTSa, CTSb) étant composé d'un mélange ayant un premier état liquide ou pâteux et un second état solide, le mélange dans son premier état liquide ou pâteux étant coulé par les canaux de coulage (101a, 101b, etc.) vers la surface externe du manteau (Ma, Mb) du corps de blindage (CTSa, CTSb).

14. Procédé pour la réalisation d'un capteur capacitif apte à détecter un champ électrique comprenant :
- un corps de blindage tubulaire (CTSa, CTSb) se dressant le long de son axe (Xa, Xb) et présentant une première extrémité ouverte (T1a, T1b) et une seconde extrémité (T2a, T2b),
- un capteur de champs électriques (Sa, Sb) positionné dans le corps de blindage tubulaire (CTSa, CTSb),
- une électrode-source (E) au-dehors du corps de blindage (CTSa, CTSb) et au voisinage de sa première extrémité ouverte (T1a, T1b),
- ou une électrode-source (Ea, Eb) avec une tige (Ea1, Eb1) qui s'étend coaxialement dans le corps de blindage tubulaire (CTSa, CSb),
- une masse de matériau isolant diélectrique (MDa, MDb) englobant le corps de blindage tubulaire (CTSa, CTSb),
- le corps de blindage tubulaire présentant un manteau (Ma, Mb) avec une plurarité de premières ouvertures passantes (Aa, Ab) de forme allongée avec un côté long (D1a, D1b) et un côté court (D2a, D2b), le côté long (D1a, D1b) s'étendant parallèlement à l'axe (X, Xa, Xb) dudit corps de blindage (CTSa, CTSb),
- la masse du matériau isolant diélectrique (MDa, MDb) dans le corps de blindage tubulaire (CTSa, CTSb) étant composé d'un mélange ayant un premier état liquide ou pâteux et un second état solide,
- ledit procédé ayant une étape opérationnelle par laquelle le mélange dans son premier état liquide ou pâteux est coulé par la pluralité des premières ouvertures passantes (Aa, Ab) dans le corps de blindage (CTSa, CTSb) de sorte que se forme la masse du matériau isolant (MDa, MDb) dans le corps de blindage (CTSa, CTSb).
